# EUROPEAN PATENT SPECIFICATION

(11) **EP 2 677 261 B1**
(45) Date of publication and mention of the grant of the patent: **10.10.2018**
(21) Application number: 12172752.3
(22) Date of filing: 20.06.2012
(51) Int. Cl.: F28D 15/02, F28F 3/14, H01L 23/427, H05K 7/20

(54) **Two-phase cooling system for electronic components**
Zweiphasiges Kühlsystem für elektronische Bauteile
Système de refroidissement biphasé pour composants électroniques

(43) Date of publication of application: 25.12.2013
(73) Proprietor: ABB Schweiz AG, 5400 Baden (CH)
(72) Inventor: Agostini, Francesco, 8005 Zürich (CH); Fabbri, Matteo, 8134 Adliswil (CH); Gradinger, Thomas, 5032 Rohr (CH)
(74) Representative: ABB Patent Attorneys

(56) References cited:
- EP-A2- 0 046 716
- WO-A2-2011/035943
- DE-U1- 9 204 152
- US-A1- 2002 083 734
- US-A1- 2006 096 742

## Description

### FIELD OF THE INVENTION

The invention relates to the cooling of electronic and electric components. In particular, the invention relates to a two-phase heat exchanger according to the preamble of claim 1 comprising an evaporator and a condenser for cooling at least one electronic and/or electric component, a power module with an electronic and/or electric component and a two-phase heat exchanger and the use of a power module with such a heat exchanger for cooling an electric and/or electronic component in a vehicle.

WO2011/035943 discloses such a two-phase heat exchanger.

### BACKGROUND OF THE INVENTION

In the field of electric and electronic devices efficient cooling systems are used to take up heat and convey the heat resulting from ohmic losses and switching losses of the electric and/or electronic components in order to prevent excessive overheating and damage or even failure to these electric or electronic components. Although the electric and electronic devices such as power converters, drives and other electric installations comprising so-called power electronic components tend to become more and more powerful in terms of electric power one can acknowledge an ongoing trend for miniaturization of that kind of electric installations. The result of these normally contravening demands is that an ever increasing amount of undesired waste heat needs to be extracted out of such installations and emitted to suitable thermal carriers such as air streams or water cycles that are tied to powerful cooling devices. In other words, the larger the compactness of an installation, the larger the power density and thus the larger the heat flux of such electric installations.

Water-cooled systems can typically deal well with high power densities. Water-cooled systems are transporting the heat by means of convection, as a heat transfer medium, i.e. the water, receives the heat and the heated water is transported from the heat source to a heat sink in order to emit the heat and to cool down the water. A drawback of water-cooled systems resides in that they tend to be costly, are prone to leakage and require usually at least one pumping device. Since pumps have moving parts that are subject to attrition, the pumps have a finite span of life and require maintenance and service. A further drawback resides in down time of the whole installation just in case of a sudden breakdown of the pump or during its maintenance, leading to undesired losses of income.

Air cooled systems are a known alternative to water-cooled systems. Typically such air cooling systems are heat sinks that comprise an array of fins extending from a base plate. Although air cooled systems are typically pumpless, at least one fan is mostly required instead to convey the thermal load emerging from the electric and/or electronic components off the fins to a stream of air acting as the thermal carrier. Within the heat sink the heat is transferred only by conduction. In the air, the thermal load is transferred by conduction proximate to the fin surface in a direction normal to the surface and by convection. The drawback of common air cooling systems resides in that a large fin surface is required if the heat transfer coefficient between fin surface and air is low. If the available space is scarce then the fins are distanced to one another often by inter-fin channels having a small width only. In addition one has to bear in mind that the higher the velocity of the air stream is, the higher is the pressure drop and the higher the level of acoustic noise caused by the fan needed to convey the air. A common measure for avoiding these drawbacks resides in dedicating a comparatively large cross-section to the air stream /airflow, e.g. in a channel or duct portion. As a result of that measure, known air cooling systems and thus the whole electric installations tend to become rather bulky since the heat sinks have usually long, thick and consequently heavy cooling fins sticking into the air stream for ensuring an acceptable fin efficiency, i.e. acceptable heat conveyance. If the inter-fin channel width is small then these inter-fin channels are prone to clogging in dirty air environment such as heavy industry or railway. Moreover the bulkiness of the overall electric installation contravenes the ongoing trend to miniaturized equipment.

Hybrid cooling systems by means of two-phase heat exchangers are known to make use of both the advantages of water-cooled systems and air-cooled cooling systems. In addition, the heat transfer coefficient of such two-phase heat exchangers is comparatively high and they may not even require pumps or fans. Exemplary embodiments of such a two phase cooler with fin-like cooling panels are addressed in WO 2011/035943 A2 disclosing a passive loop-type thermosiphon cooling system. In WO 2011/035943 A2, two different concepts of a cooling system with a condenser made of roll-bonded panels were disclosed. In the first concept, evaporator and condenser are spatially separated and connected only through pipes and/or a manifold (see the embodiments shown in figures 1-9 of WO 2011/035943 A2 for exemplary reference). In the second concept, the evaporator and the condenser are spatially integrated to a system that essentially looks like a classical, finned heat sink, i.e. it has a base plate, onto which the power electronic devices to be cooled can be mounted, and fins, which extend from the base plate, in a direction normal to the base plate. The second concept (see the embodiments shown in figures 11-14 of WO 2011/035943 A2 for exemplary reference) is advantageous in so far as it allows replacing power modules with cooling systems having classical finned heat sinks by a two-phase thermosiphon with similar appearance and overall dimensions. Compared to a classical finned heat sink, the thermal efficiency of a cooling system according to the second concept is much higher, because the heat in the fins is not only transported by conduction, but also by convection of the two-phase working fluid flowing in the channels of the roll-bonded panels, which constitute the fins. The thermal fin efficiency is that high that the second concept allows the cooled power-electronic devices to be operated with higher power and higher losses compared to a common cooling systems relying on known above-mentioned heat sinks. At the same time overheating of the electric and/or electronic devices to be cooled is preventable in a reliable manner by the second concept. Alternatively, the higher cooling efficiency can increase the lifetime and the reliability of the power-electronic devices if the power and the losses of the power-electronic devices are kept constant.

Although the second concept is thermally convincing and requires structurally less complex designs and assembly than the first concept, the second concept is difficult to manufacture in an economic way. According to the second concept, a lower part of each panel including a section of the channel is inserted in a dedicated slot of the base plate. The whole base plate has several slots to receive the panels conferring a comb-like appearance to the base part when seen in a cross-section. For ensuring a good thermal performance, it is important that the thermal resistance between the slot walls and the panel surface of the roll-bonded panels is small. Expressed differently, an intimate contact between roll-bonded panels and the slot walls of the base is essential. Even with known mass production technology both the manufacture of the slots and a satisfactory thermal contact between the slots and the roll-bonded panels is dissatisfactory in terms of economy.

### SUMMARY OF THE INVENTION

It is thus an object of the present invention to simplify the mechanical connection in between the roll-bonded panels and the base plate of a two-phase thermosiphon according to the second concept mentioned above such that a more economic manufacturing process is achievable.

This object is achieved by a two-phase heat exchanger according to claim 1.

A basic embodiment of the inventive two-phase heat exchanger for cooling at least one of an electronic and/or an electric component comprises a condenser body that is thermally connected to an evaporator body. The condenser body comprises a plurality of roll-bonded panels where a first channel for a phase-changing working fluid is arranged in between a first and a second sheet such that a first connection port delimits the first channel at one end and that a second connection port delimits the first channel at another end. The first sheet is connected to the second sheet by roll-bonding such that a roll-bonded panel is formed. The evaporator body comprises a second channel, wherein said second channel is delimited at one end by a third connection opening for each roll-bonded panel and at another end by a fourth connection opening for each roll-bonded panel. The evaporator body comprises a connection surface to which at least one of an electronic and an electric component is thermally connectable.

Further, each first connection port is connected to a corresponding third connection opening and each second connection port is connected to a corresponding fourth connection opening such that the first channel and the second channel form a closed loop for guiding a working fluid that receives a thermal load producible by the at least one of an electronic and an electric component in an operating state of the heat exchanger at the evaporator body and from the evaporator body to the condenser body for dissipating the thermal load. Moreover, the third connection openings are arranged in a first end region of the evaporator body wherein the fourth connection openings are arranged in a second end region of the evaporator body. Said second end region is provided on an opposite end of the evaporator body with respect to the first end region, e.g. on opposite sides if the evaporator body has a cuboid overall shape such that a compact heat exchanger is achievable. The term 'connection port' shall not be understood in a limited way for denoting merely an orifice, a hole or an opening but as a three-dimensional element, for example a pipe or hose, which element forms a portion of the loop-type channel in between the first channel and the second channel that forms a fluid connection, e.g. a fluid duct, for the working fluid.

The simplification of the mechanical connection between the roll-bonded panels and the base plate, i.e. the evaporator compared to prior art devices is achieved in that the evaporator body is designed to act as the actual evaporator for the working fluid and is thus a bodily different element than the condenser body. This is achieved by the second channel that forms itself an essential portion of the loop for the working fluid. As a result, the roll-bonded panel does not contain an evaporator portion any longer such that there is no need to embed the roll-bonded panel into the base plate/evaporator body. As a consequence, the base plate/evaporator body does not need to comprise any slots for receiving the roll-bonded panels any more. By doing so, the degree of design freedom for connecting the evaporator body to the roll-bonded panels, the evaporator body geometry as well as the evaporator panel is increased to a maximum extent. Thus it becomes possible to connect an evaporator that is not manufactured by roll-bonding technology to roll-bonded panels forming the condenser. Moreover, a thermal interface of the conveyed heat from the base plate/evaporator to the roll-bonded panels as present in the thermosiphons according to the second prior art concept is avoided. Thermal interfaces are undesired since they decrease the efficiency heat transport of a heat exchanger and thus affect the overall thermal efficiency.

The degree of design freedom for connecting the evaporator body to the roll-bonded panels is further increased in that the third connection openings and the fourth connection openings are allocated in different, opposite end regions of the evaporator body. Owing to that spatial separation of the third connection openings and the fourth connection openings, the accessibility to the connection ports and their dedicated connection openings is heavily improved and contributes thus to an economic manufacturing process. In an exemplary embodiment a distance between the first end region and the second end region may be at least 0.5 times as long as the second channel of the evaporator body.

Moreover, a given length of the evaporator body can be used thermally optimal over almost its whole length if the at least one of an electric and an electronic component forming the heat source is allowed to extend over a substantial portion of that given length.

Depending on the embodiment of the evaporator body that forms the base plate, the thermal connection can be established in that the at least one of an electronic and an electric component is pressed directly to the connection surface or indirectly, e.g. in that an intermediate layer of a good thermal conductor such as copper or the like and/or a thermal grease is provided between the at least one of an electronic and an electric component and the connection surface. Where allowable, the at least one of an electronic and an electric component may be pressed towards the evaporator body by fastening these components directly to the evaporator body.

The number of roll-bonded panels of the condenser body depends on the heat output that shall be conferred to the thermal carrier like ambient air, for example. Hence embodiments of heat exchangers are achievable where several condenser bodies are fluidly connected to the evaporator body by several sets of a third connection opening and a fourth connection opening each.

The heat exchanger is charged with a working fluid that is allowed to circulate in the first channels and second channels in order to convey heat by means of convection from the evaporator body to the condenser panels by flowing from the second channel through the first connection opening or the second connection opening of the evaporator towards the first channel. Any working fluid, also referred to as refrigerant or coolant, can be used. Depending on the conditions and requirements some suitable examples of a working fluid are R134a, R245fa, R365mfc, R600a, carbon dioxide, methanol and ammonia.

The roll-bonded panels may be connected to the evaporator with a plug connection. Preferably, the actual connection of the roll-bonded panels to the evaporator is performed by brazing or welding such that the roll-bonded panels are not removable from the evaporator after assembly. Such a connection may improve the structural integrity of the two-phase heat exchanger. Brazed or welded thermosiphon heat exchangers are further known to form lasting leak-proof connections of cooling systems. Provided that the inter-fin channel width or spacing, i.e. the distance in between two neighboring roll-bonded panels is large enough, clogging can be avoided easily.

In an economic way of manufacturing the thermosiphon heat exchanger the condenser body and the evaporator body are connected to one another in one shot by CAB brazing (e.g. NOCOLOK®) or vacuum brazing.

The two-phase heat exchanger as described above and hereinafter works on the principle of thermosiphon systems. Thus, a pump is not needed to drive the circulation of the working fluid. When being vaporized in the evaporator, the working fluid vaporizes and rises from the evaporator to the roll-bonded panels, where the vaporized working fluid is condensated again. The condensated working fluid flows towards the evaporator, thus constituting a closed loop cooling circuit.

According to the thermosiphon principle, the flowing of the working fluid through the cooling circuit is held up by gravity and the different density of the vaporized and condensed working fluid.

The electronic and/or electric component may be every component that produces heat during its operation and needs to be cooled down, e.g. a power electonioc component. The term power electronic components is used hereinafter for diodes, thyristors and other semiconductor elements whose block-voltage is more than 400 Volts such that can be used in a power module, e.g. for a drive or converter of a mill, a vehicle and the like.

The evaporator is adapted to be connected to a multitude of roll-bonded panels. Thus, the working fluid rises in one of the multitude of roll-bonded panels through the first connection port or the second connection port when being vaporized in the evaporator and condensates when flowing through the first channel of the roll-bonded panel. After condensating back to its liquid state, the working fluid flows from the roll-bonded panel through the second connection port or the first connection port back to the second channel of the evaporator where the cycle starts anew.

According to an embodiment of the invention, the first connection port and the second connection port of the first channel are located on a single edge of the roll-bonded panel.

Particularly good access to the connection openings and the connection ports is achievable if the third connection opening or openings and the fourth connection opening or openings are arranged on a common surface of the evaporator body. Owing to such a set-up the connection of the roll-bonded panels to the evaporator can be simplified.

In a basic design of the evaporator body the common surface where the roll-bonded panels are attachable to is arranged on an opposite end/side of the connection surface on the evaporator body where the at least one electronic and/or electric component is thermally connectable.

Depending on the embodiment of the roll-bonded panel, the connection ports may comprise a tubular end section, e.g. a tube section that is brazed to the roll-bonded sheets. If the connection ports are attached to the roll-bonded sheets, the bending stiffness of the connection ports decreases with increasing length of the connection ports. This effect can be targeted on purpose for compensating dimensional mismatches between the end portion of the first connection port facing the third connection opening and said dedicated third connection opening if the end portion of the second connection port facing the dedicated fourth connection opening matches its dedicated fourth connection opening. Reasons for dimensional mismatches may reside in manufacturing tolerances in terms of dimension and shape of both the evaporator body and the roll-bonded panels, different thermal expansion of the evaporator body and the roll-bonded panels or a combination thereof.

In a basic embodiment for compensating such mismatches the first connection port is longer than the second connection port when seen in a flow direction of the working fluid in an operating state of the heat exchanger. The first connection port is that flexible such that it allows for compensating dimensional mismatches between the second connection port and the third connection opening.

Where suitable and required, the second channel can be split into at least two sub-channels between the third connection openings and the fourth connection openings, e.g. if the overall wetted surface of the evaporator body has to be maximized.

The first channel or channels shall be shaped and dimensioned according to the particular needs and requirements of the thermosiphon heat exchanger. The first channel might be split up into a set of sub-channels at the first connection port and bundled again at the second connection port in order to distribute the vaporized working fluid to a large surface of the condenser panel for condensation. Alternatively or in addition the first channel may be provided in the roll-bonded panel to have a serpentine-like appearance. In any case it might be advantageous to adjust the inclination of the first channel and its subsections such that a motion (flow) of the working fluid can be promoted merely by gravity such that no pumps are required. Similar measures may be taken if the working fluid shall have a predefined flow direction.

In a possible basic embodiment of the evaporator body the latter may comprise a base part with the second channel and a cover plate for vertically closing the second channel.

If the heat flow from the evaporator body into the working fluid exceeds a predefined threshold, a vapor promoting structure may be provided in the second channel for improving the vaporization rate. The vapor promoting structure may be any shape of the interior surface of the evaporator which supports a high heat transfer from the base part (where the heat sources are connected to, i.e. the electronic and/or electric components) to the working fluid. Thus, the base part may itself have a vapor promoting structure with an increased surface. The purpose of the vapor promoting structure resides in increasing the wetted surface by creating sub-channels and decreasing the local heat flux in order to avoid the critical heat flux. Critical heat flux describes the thermal limit of a phenomenon where a phase change occurs during vaporization (such as bubbles forming on a metal surface used to heat the working fluid), which suddenly decreases the efficiency of heat transfer, thus causing local overheating of the heating surface.

According to an embodiment of the evaporator body, the vapor promoting structure can have a honey-comb-like cross section when seen in the direction of the flow in the second channel such that a plurality of parallelly extending sub-channels is formed. The comb-like cross section of the base plate consists of peaks and valleys or ridges and recesses, wherein each recess may be adapted in order to form a second channel or sub-channel when covering the base part with the cover plate. Depending on the embodiment, the recesses forming the second channel or second channels are provided in the base part only, in the cover plate only or partially in both the cover plate and the base plate.

The recesses of the base part having the comb-like cross section may also be interconnected such that the working fluid is collected in a manifold, wherefrom the vaporized working fluid flows towards the roll-bonded panels in an operating state of the thermosiphon.

According to a further embodiment of the evaporator body, the evaporator body comprises a first manifold and/or a second manifold, wherein the first manifold is adapted to supply a plurality of second channels, in particular second channels that run in parallel to one another, with condensed working fluid in its liquid state flowing out of the second connection port of the first channel and wherein the second manifold is adapted to supply working fluid from the second channels to the first connection port of the first channel. Good vaporization results are achievable due to an increased contact surface of the evaporator body to the working fluid if a majority of a length of the second channel or a sub-channel thereof is formed by a multi-port-extrusion (MPE) tube. Alternatively or in addition thereto the second channel might be split into at least two sub-channels between the first connection port and the second connection port for increasing the wetted overall surface of the evaporator body. Accordingly, the second manifold receives the vaporized working fluid from the second channels of the evaporator and supplies the vaporized working fluid to the roll-bonded panels for condensation.

According to a further aspect of the invention, a power module comprising at least one two-phase heat exchanger as described above where at least one electronic and/or electric component is thermally connected to the connection surface of the evaporator body of the two-phase heat exchanger. The advantages mentioned in the context of the two-phase heat exchangers apply likewise to those of a power module having such a heat exchanger. The advantages mentioned earlier predestine the power module described above for being used in a vehicle. The vehicle may be a bus, a train, a ship or an aircraft, for example. In particular, the electric component may be a power supply unit such as a traction power converter or an auxiliary converter used in a train.

These and other aspects of the present invention will become apparent from and elucidated with reference to the embodiments described hereinafter.

### BRIEF DESCRIPTION OF THE DRAWINGS

Fig. 1 shows a simplified front view of a power module comprising a two-phase heat exchanger according to an exemplary embodiment of the invention.
Fig. 2 shows a perspective view of the power module according to a further exemplary embodiment of the invention from the top left angle.
Fig. 3 shows a perspective view of the power module of Fig.3 from the top right angle with a section through the heat exchanger along A-A of Fig. 1 and Fig.2.
Fig. 4 shows a perspective view of an evaporator of the heat exchanger shown in Fig. 2.
Fig. 5 shows a perspective view of a base part of the evaporator shown in Fig. 4.
Fig. 6 shows a cross sectional view through the base part shown in Fig. 5 along section B-B.
Fig. 7 shows a cross sectional view through an alternative base part.
Fig. 8 shows a side view of a further embodiment of a heat exchanger.
Fig. 9 shows a perspective view of a further embodiment of a power module with a two-phase heat exchanger according to a further exemplary embodiment.
Fig. 10 shows a perspective view of the power module according to Fig. 9 comprising a sectional view through the condenser body and the evaporator body along section C-C in Fig. 9.
Fig. 11 shows a perspective view of the power module according to Fig. 9 comprising a sectional view through the evaporator body along section D-D in Fig. 9.
Fig. 12 shows a close-up of an exploded view of the power module according to Fig. 9 in a similar perspective as in Fig. 9 comprising a sectional view through the evaporator body and the condenser body along section E-E in Fig. 9.
Fig. 13 shows a perspective view of the evaporator body of the embodiment of the power module shown in Fig. 9.
Fig. 14 shows a simplified side view of an exemplary roll-bonded condenser panel.
Fig. 15 shows possible orientations of the two-phase heat exchanger according to the present application with respect to the direction of the gravitational force of the earth (G) in an operating state of the power module.

In the following description of exemplary embodiments of the invention, identical or at least functionally identical parts or elements are provided with the same reference numerals in the figures. The exemplary embodiments shown in the figures are schematical and not drawn to scale.

### DETAILED DESCRIPTION OF EXEMPLARY EMBODIMENTS

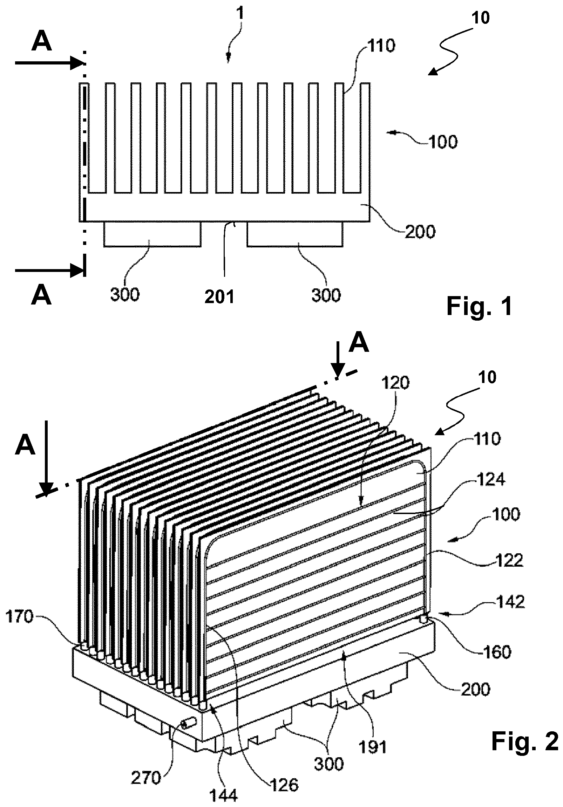

Fig. 1 shows a simplified schematic view of a power module comprising a two-phase heat exchanger 1 according to an exemplary embodiment of the invention. The heat exchanger 1 is employed for cooling at least one of an electronic and an electric component 300 comprising an evaporator body 200 and a condenser body 100. The condenser body comprises a plurality of roll-bonded panels 110. These roll-bonded panels 110 are produced from aluminum sheet metal and are thermally and mechanically permanently connected to the evaporator body 200 such that the heat exchanger 1 has a comb-like overall appearance like a conventional finned heat sink when see in cross-section. The roll-bonded panels 110 of the condenser 100 and the evaporator 200 are connected or joined by CAB (controlled atmosphere brazing) or flame-brazing. Alternatively, the joining of the roll-bonded panels and the evaporator may be performed with any other feasible and appropriate means such as adhesives, e.g. epoxy resin.

One or more electric or electronic components 300 are attachable/attached to and their contact surface thermally connectable/connected to the evaporator 200, e.g. by way of fastening, on a connection surface 201 in order to establish a thermally suitable heat transfer of the components 300 to a working fluid like R134a, for example, contained in the evaporator body 200.

Fig. 2 shows a perspective view of the power module according to a further exemplary embodiment of the invention from the top left angle.

The roll-bonded panels 110 of the condenser body 100 are connected to the evaporator body 200 via connection ports 142, 144, which connection ports comprise an inlet and/or outlet tube 160, 170 that allow the working fluid to move from the evaporator body 200 to the condenser body 100 and vice versa. The evaporator body 200 comprises a filler plug 270 for charging the evaporator body 200 with the working fluid after manufacturing of the two-phase heat exchanger. The roll-bonded panels 110 have a first channel 120 for receiving the vaporized working fluid coming from the evaporator body each, such that the working fluid condenses when flowing through the first channel 120 of the roll-bonded panel 110 in an operating state of the power module. In the exemplary set-up of the roll-bonded panels 100 shown in Fig.1, the first channel 120 departs from the first connection port 142 and comprises a first portion 122 from where a plurality of third portions 124 running parallel to one another branches off. All these third portions 124 are fluidly connected to a single second portion 126 which in turn is fluidly connected to the second connection port 144.

Both the first connection port 142 and the second connection port 144 are located at a common first edge 191 proximate to a lateral edge of the roll-bonded panel 110, wherein the condenser panels 110 are provided on an opposite end to the connection surface 201 of the evaporator body.

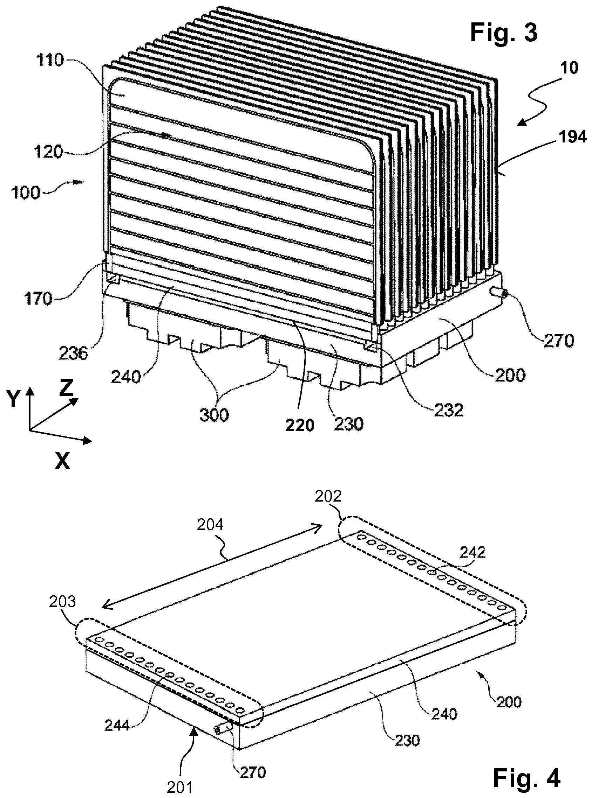

Fig. 3 shows a perspective view of the power module of Fig.3 from the top right angle with a section through the heat exchanger along A-A of Fig.1 and Fig.2. Compared to Fig.2, the heat exchanger is rotated about a vertical axis (Y) defined by the first portion 122 of the first channel 120, for example. Please note that the sectional surface along A-A is not shown in hatched style by exception as the hatched display might hamper the understandability and clarity of the cross-section.

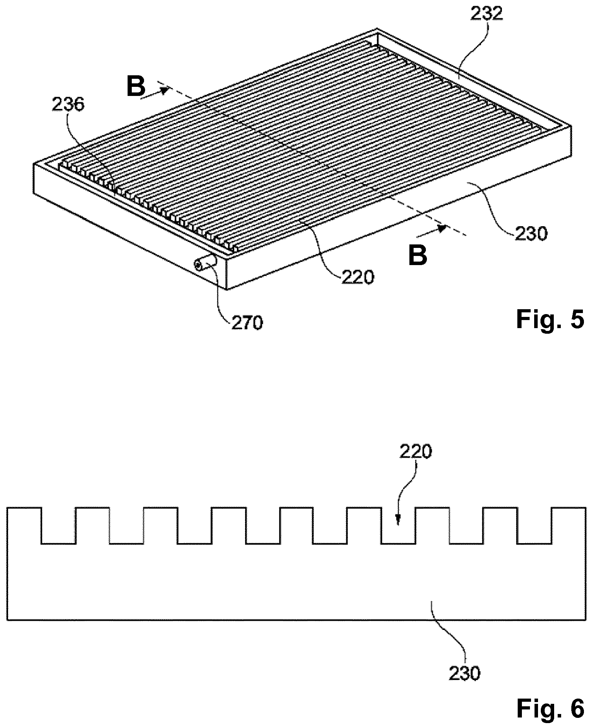

The evaporator body 200 comprises a base part 230 comprising a second channel 220 and a cover plate 240 for vertically delimiting a set of longitudinal portions of the second channel 220 that run parallel to one another in the same direction as the roll-bonded panels 110 (direction X). Both the base part 230 and the cover plate 240 are made of aluminum or an alloy thereof that is suitable for being brazed together and to the roll-bonded condenser body 100. The vaporization of the working fluid takes place within these longitudinal portions of the second channel 220 in an operating state of the heat exchanger. The evaporator body 200 comprises further two recesses 232, 236, one arranged at each end face of the evaporator body 200, which recesses extend transversely (direction Z) to the longitudinal direction of the longitudinal portions of the second channel 220. Said longitudinal portions of the second channel 220 discharge at their ends into these recesses such that these recesses form a first manifold 232 and a second manifold 236, respectively. For further reference to the set-up of the base part 230 revert to Figures 5 and 6 and the description relating thereto.

The roll-bonded panels 110 are connected to the evaporator 200 via the inlet tubes 160 and outlet tubes 170 forming the first connection port 142 and the second connection port 144 respectively such that the vaporized working fluid is allowed to rise in its vapor state from the first manifold 232 to the first channel 120 of the roll-bonded panels 110 and the condensed working fluid is allowed to flow back to the second manifold 236 in its liquid state again for a new working cycle again in an operating state of the heat exchanger.

The first channel 120 and the second channel 220 form a loop for guiding the working fluid within the heat exchanger 1. The movement of the working fluid in the operating state of the heat exchanger of this embodiment is driven by gravitation.

Fig. 4 shows a perspective view of an evaporator of the heat exchanger shown in Fig. 2. The evaporator 200 comprises a base part 230 and a cover plate 240, wherein the cover plate 240 comprises a set of third connection openings 242 and a set of fourth connection openings 244 each. The set of third connection openings 242 is arranged in a linear manner in a first end region 202 of the evaporator body 200. The set of fourth connection openings 244 is provided the same way at a second end region 203 located at an opposite end of the evaporator body 200 with respect to the first end region 202. The second end region 203 is separated from the first end region 202 by a distance 204. The third connection openings 242 are provided for receiving the first connection ports 142 during assembly of the heat exchanger whereas the fourth connection openings 244 are provided for receiving the second connection ports 144. Thus, the connection openings 242, 244 are adapted to be connected via connection ports 142, 144 and/or connection tubes 160, 170 to the roll-bonded panels of the condenser body 200 accordingly.

Fig. 5 shows a perspective view of a base part of the evaporator shown in Fig. 4. As already mentioned in the context of Fig. 3 and with reference to Fig. 6, Fig. 5 displays that the plurality of longitudinal portions of the second channel 220 discharges at their ends into the first manifold 232 and the second manifold 236, respectively. The number of longitudinal portions of the second channel results of a compromise between a maximum number of second channels for improving the heat transfer from the base part to the working fluid and the increase in detrimental pressure drop and a blockage of the natural circulation of the working fluid where only as few channel portions as possible are desirable.

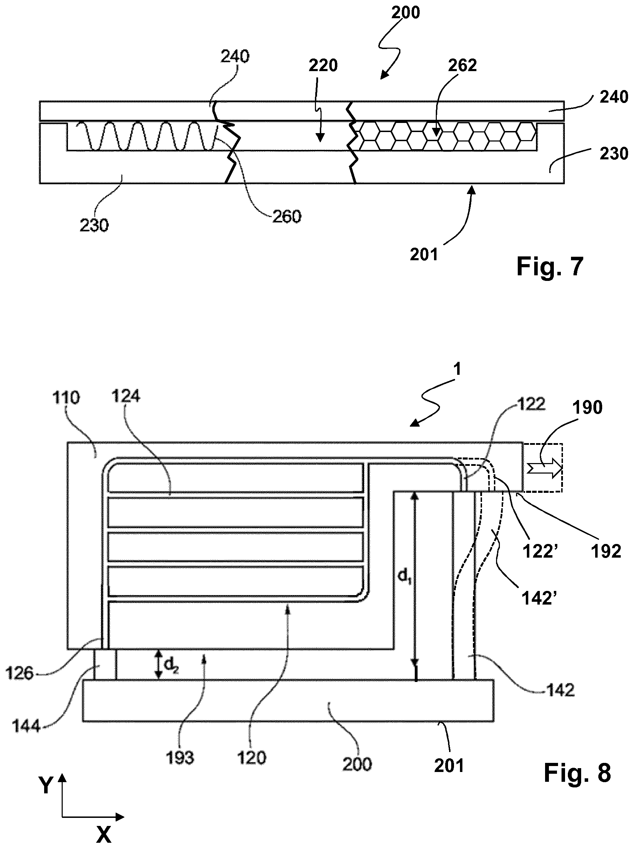

Fig. 7 shows a cross sectional view presented similar to Fig. 6 through an alternative base part. In difference to the base part referred to in Figs. 4 to 6 the base part 230 according to this embodiment comprises merely a single longitudinal portion of the second channel 220 discharging at its ends into the first manifold 232 and the second manifold 236. A vapor promoting structure 260, 262 is provided in said longitudinal portion of the second channel 220 for improving the efficiency of the heat transfer from the evaporator body 200 to the working fluid by increasing the creation of nucleation sites for vaporizing the working fluid in an operating state of the evaporator body 200. The term 'vapor promoting structure' shall not be misunderstood as a conventional porous structure but as a blanket term for a structure for forming a plurality of sub-channels for enhancing the overall surface within the evaporator where the vaporization takes place, i.e. for enhancing the overall surface wetted by the working fluid in the evaporator.

Fig. 7 displays two possible embodiments of vapor promoting structure for achieving good vaporization results. The first embodiment shown in the left hand side fractional view of Fig. 7 has a vapor promoting structure 260 with a zigzag cross-section. In this embodiment, the vapor promoting structure 260 is formed by a corrugated sheet metal that is connected to the base part 230 and the cover plate 240 e.g. by brazing in one shot together with the connection of the cover plate 240 to the base part 230. Said vapor promoting structure 260 forms a plurality of sub-channels that extend parallel to one another in the direction X.

The vapor promoting structure is formed by a folded fin 260 that is located within the second channel 220 in order to increase the heat transfer from the base part to the working fluid and to improve the efficiency of the heat transfer to the working fluid such that vaporization of the working fluid is further promoted.

The fractional view on the right hand side of Fig. 7 features a vapor promoting structure 262 having a honey-comb cross-section. Said vapor promoting structure 262 may be an extruded metal profile that is connected to the base part 230 and the cover plate 240 e.g. by brazing in one shot together with the connection of the cover plate 240 to the base part 230. Said vapor promoting structure 262 forms a plurality of sub-channels that extend parallel to one another in the direction X.

Fig. 8 shows a side view of a further embodiment of a heat exchanger. The movement of the working fluid in the operating state of the heat exchanger of this embodiment is driven by gravitation, too. The roll-bonded panel 110 is again connected to the evaporator body 200 via the first connection port 142 and the second connection port 144. In contrast to the embodiments described above where the first connection port 142 and the second connection port 144 were located at a straight first edge 190 of the roll-bonded panel 110, is the first connection port 142 of this embodiment now located on a first edge area 192 of the first edge 190 facing the evaporator body 200. The first edge area 192 is vertically displaced to the second connection port 144. Said second connection port 144 is still located on a second edge area 193 in the area where the formerly common, straight first edge 190 of the aforementioned embodiments was located. In other words, the first edge area 192 and the second edge area 193 are stepped against each other with respect to the evaporator or a surface of the cover plate oriented towards the roll-bonded panel. In ther words, the first edge area 192 of the condenser body 100 runs at a first distance d1 to the evaporator surface facing the condenser. Similarly thereto runs the second edge area 193 of the condenser body 100 at a second distance d2 to the evaporator surface facing the condenser wherein the first distance d1 is larger than the second distance d2. Both the first distance d1 and the second distance d2 extend in the vertical distance (direction of Y). When connecting the pre-manufactured condenser body 100 to the pre-manuafctured evaporator body 200 the ability of the first connection port 142 to be deformed and thus allowing a lateral deflection proofs particularly useful for heat exchangers whose roll-bonded panels are subject to comparatively large dimensional tolerances of up to several millimeters already at an intended distance between the first connection port 142 and the second connection port 144 of about 400 mm, for example. Those tolerances occur due to the intrinsic manufacture tolerances of the roll-bond panels due to the manufacturing process involving a rolling operation. In contrast thereto, the third connection opening 242 and the fourth connection opening 244 dedicated to the roll-bonded panel 110 is cast or machined into the evaporator body 200 with comparatively small tolerances. Because of its rather high stiffness, the evaporator body 200 cannot compensate for large manufacturing tolerances. The comparatively flexible first connection port 142 allows for connecting the free end of the first connection port 142 facing the third connection opening 242 dedicated for receiving the first connection port 142 even if there is a dimensional mismatch in the X-direction between the intended beginning of the first connection port 142 adjacent to the first portion 122 of the first channel 120 and the actual beginning of the first connection port 142 adjacent to the misaligned first portion 122' of the first channel 120 or a form/shape mismatch.

A further advantage of this embodiment resides in that the flexibility of the first connection port 142 allows a substantial change in length of the roll-bonded panel 110 due to differing thermal expansion between the beginning of the first connection port 142 and the second connection port, delimiting the first channel 120 longitudinally. Fig. 8 displays a heat exchanger whose first connection port 142' is deflected at the proximate end to the roll-bonded panel 110.

The reference numeral 190 denotes a mismatch in location of that end of the roll-bonded panel 110 to which the beginning of the first connection port 142 is attached, regardless whether said mismatch is originating from manufacturing tolerances, differing thermal expansion or a mixture thereof.

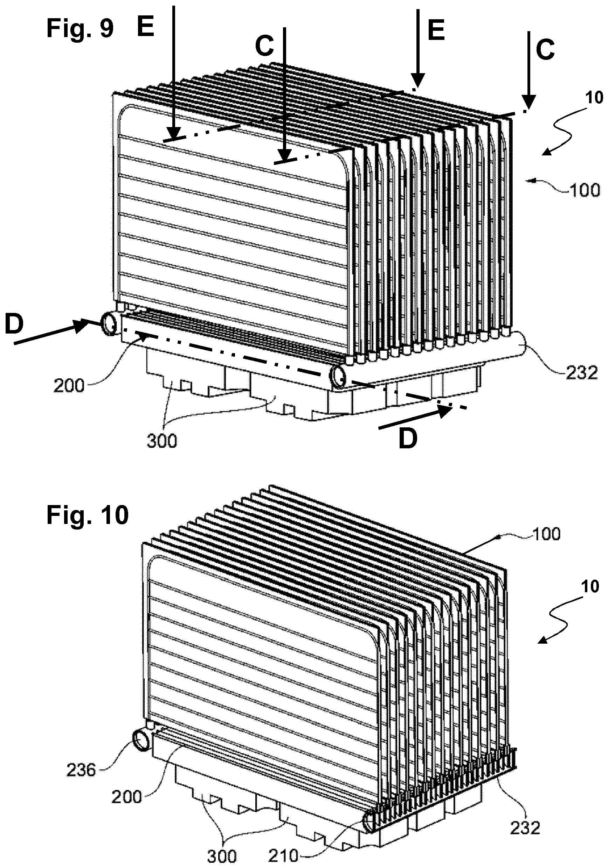

Fig. 9 shows a perspective view of a further embodiment of a power module with a two-phase heat exchanger according to a further exemplary embodiment. In contrast to the embodiment of the power module shown in Fig. 3, the first manifold 232 and the second manifold 236 of this embodiment are now formed by tubes or pipes that are sealed at their end faces and are arranged along the end faces of the base part 230 of the evaporator body. The third and fourth connection openings are provided in the pipe forming the first manifold 232 and the second manifold 236, respectively. In contrast to the embodiments of the above-mentioned evaporators, this evaporator body does not need a cover plate for vertically delimiting the longitudinal portion of the second channel since said portion is provided and laterally delimited by a plurality of multi-port extruded (MPE) tubes 210 that will be explained with reference to Fig. 10 below.

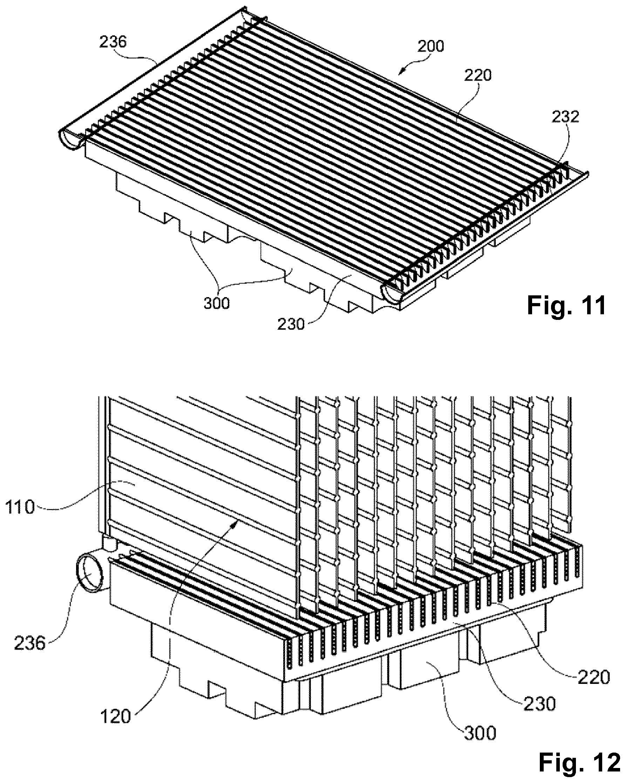

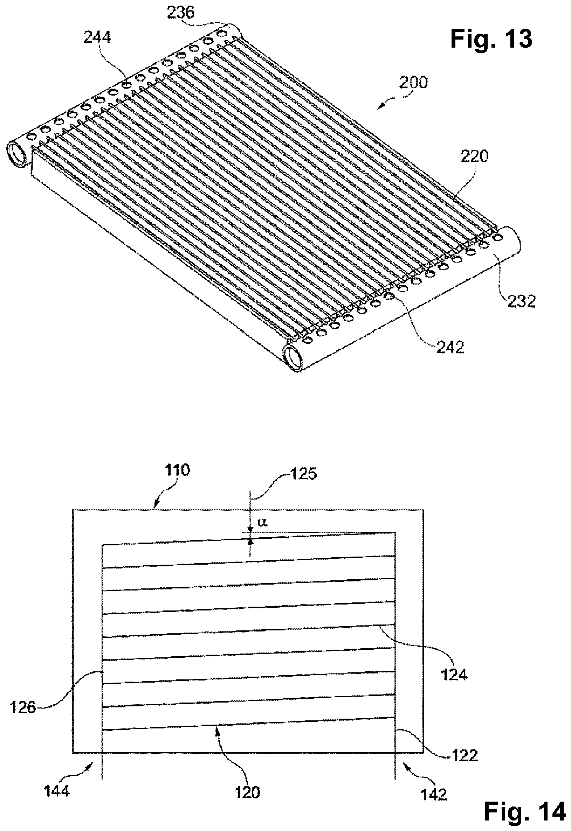

Fig. 10 shows a perspective view of the power module according to Fig. 9 comprising a sectional view through the condenser body and the evaporator body along section C-C in Fig. 9. A perspective view of the evaporator body according to this embodiment is shown in Fig. 13. Together with Fig. 11 it can be seen that the longitudinal portions of the second channels within the evaporator body 200 are formed by means of MPE tubes 210 dedicated to each of these second channel portions. An MPE tube is an element consisting of a multitude of channels, e.g. six channels. An MPE tube 210 is an inexpensive extruded metal profile, e.g. made of aluminum or an alloy thereof. Each of the sub-channels of each multiport extruded tube 210 discharges into one of the second manifold 236 or the first manifold 232. The detailed set-up of this arrangement is visible in Fig. 12, showing a close-up of an exploded view of the power module according to Fig. 9 in a similar perspective as in Fig. 9 and comprising a sectional view through the evaporator body and the condenser body along section E-E in Fig. 9. The sectional area along E-E is not shown in hatched style as the latter might hamper the understandability and clarity of the cross-section.

The vaporization of the working fluid takes place within the sub-channels of the MPE tubes 210 that provide for a large interior surface wetted by the working fluid. For ensuring a good thermal transfer from the base part 230 to the working fluid, the base part 230 features a number of longitudinal slots matching the number of MPE tubes 210. The MPE tubes 210 are bonded to the base part 230 by means of brazing, for example. Depending on the embodiment, the brazing of the MPE tubes 210 to the base part 230 as well as the first manifold 232 and the second manifold 236 to the base part 230 may be performed in one shot to form an evaporator body 200 as shown in Fig. 13. The number of MPE tubes 210 does not necessarily need to be the same as the number of roll-bonded panels 110 conferring good freedom of design properties to this heat exchanger.

Fig. 14 shows a simplified side view of an exemplary roll-bonded condenser panel. The difference of the roll-bonded panel 110 of Fig. 14 to the roll-bonded panel 110 of the embodiment shown in Fig. 2 resides in that the third portions 124 are inclined by an angle α which angle is denoted by reference numeral 125 with respect to said first portion 122 extending in the direction Y. The inclination is provided for conferring a predefined flowing direction to the working fluid in an operating state of the thermosyphon, if required.

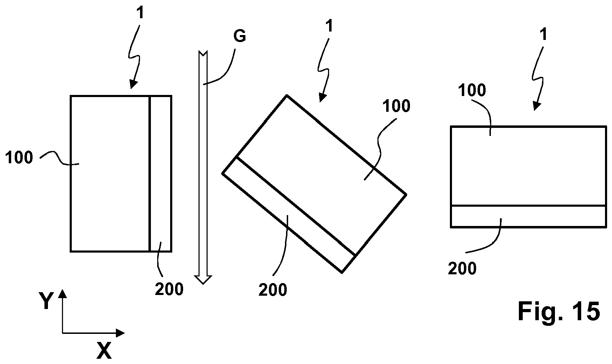

Fig. 15 shows possible orientations of the two-phase heat exchanger 1 according to the present application with respect to the direction (Y) of the gravitational force of the earth (arrow denoted by capital letter "G") in an operating state of the power module. The evaporator 200 may be arranged horizontally and vertically as well as inclined with respect to a direction Y of the gravitation force G, wherein the roll-bonded panels are oriented upwards, i.e. away from the gravitation force, in the inclined variant.

While the invention has been illustrated and described in detail in the drawings and the foregoing description, such illustration and description are to be considered illustrative or exemplary and not restricted; the invention is not limited to the disclosed embodiments.

Other variations of the disclosed embodiments may be understood and effected by those skilled in the art and practicing the claimed invention, from a study of the drawings, the disclosure, and the appended claims.

In the claims, the word "comprising" does not exclude the presence of other elements or steps, and the indefinite article "a" or "an" does not exclude a plurality. The mere fact that a certain measures are recited in mutually different dependent claims does not indicate that a combination of these measures may not be used to advantage. Any reference signs in the claims should not be construed as limiting the scope.

## Claims

1. A two-phase heat exchanger (1) for cooling at least one of an electronic and an electric component (300), the heat exchanger (1) comprising:
a) a condenser body (100) comprising a plurality of roll-bonded panels (110), wherein a first channel (120) is arranged between a first and a second sheet such that for each roll-bonded panel a first connection port (142) delimits the first channel (120) at one end and that a second connection port (144) delimits the first channel (120) at another end,
wherein each first sheet is connected to a corresponding second sheet by roll-bonding such that a roll-bonded panel (110) is formed, and
b) an evaporator body (200) comprising a second channel (220), wherein said second channel (220) is delimited at one end by a third connection opening (242) for each roll-bonded panel (110) and at another end by a fourth connection opening (244) for each roll-bonded panel (110),
wherein the evaporator body (200) comprises a thermal connection surface (201) to which at least one of an electronic and an electric component is thermally connectable,
wherein each first connection port (142) is connected to a corresponding third connection opening (242) and wherein each second connection port (144) is connected to a corresponding fourth connection opening (244) such that the first channels (120) and the second channel (220) form a loop for guiding a working fluid that receives a thermal load producible by the at least one of an electronic and an electric component (300) in an operating state of the heat exchanger (1) at the evaporator body (200) from the evaporator body (200) to the condenser body (100) for transferring the thermal load, and wherein the third connection openings (242) are arranged in a first end region (202) of the evaporator body (200) and **characterized in that** the fourth connection openings (244) are arranged in a second end region (203) of the evaporator body (200),
wherein the second end region (203) is provided on an opposite end of the evaporator body (200) with respect to the first end region (202).

2. The two-phase heat exchanger of claim 1,
wherein the third connection opening (242) and the fourth connection opening (244) are arranged on a common edge of the evaporator body (200).

3. The two-phase heat exchanger of claim 2,
wherein the common edge is arranged on an opposite side of the connection surface (201) on the evaporator body (200).

4. The two-phase heat exchanger according to claim 3,
wherein the first connection port (142) and the second connection port (144) are arranged at a first edge (191) of the condenser body (100), said first edge (191) facing the common surface of the evaporator body (200).

5. The two-phase heat exchanger according to claim 4,
wherein the first edge (191) of the condenser body (100) runs proximate to the common surface of the evaporator body (200).

6. The two-phase heat exchanger according to any one of claims 2 to 5,
wherein the first connection port (142) is longer than the second connection port (144), and
wherein the first connection port (142) is that flexible that it allows for compensating mismatches between the second connection port (144) and the third connection opening (242).

7. The two-phase heat exchanger according to any one of the preceding claims,
wherein several condenser bodies (100) are fluidly connected to the evaporator body (200) by several sets of a third connection opening (242) and a fourth connection opening (244) each.

8. The two-phase heat exchanger according to claim 7,
wherein at least two of the third connection openings (242) and at least two of the fourth connection openings (244) are fluidly interconnected by a common second channel (220).

9. The two-phase heat exchanger according to claim 8,
wherein the second channel (220) is split into at least two sub-channels in between the third connection openings (242) and the fourth connection openings (244).

10. The two-phase heat exchanger according to any one of the preceding claims,
wherein at least one vapor promoting structure (260, 262) is arranged in the second channel (220).

11. The two-phase heat exchanger of claim 10,
wherein the vapor promoting structure (260, 262) has structure which, when seen in cross section in a flow direction of the working fluid in an operating state of the heat exchanger, forms a plurality of sub-channels of the second channel (220).

12. The two-phase heat exchanger according to any one of claims 1 to 9,
wherein a portion of a length of the second channel (220) or a sub-channel thereof is formed by a multi-port tube, in particular a majority of the length of the second channel (220) or the sub-channel thereof.

13. The two-phase heat exchanger according to any one of the preceding claims,
wherein the first channel (120) is split into at least two sub-channels between the first connection port (142) and the second connection port (144).

14. The two-phase heat exchanger according to any one of the preceding claims,
wherein the condenser body (100) and the evaporator body (200) are connected to one another in one shot by CAB brazing or vacuum brazing.

15. A power module (10), comprising:
a two-phase heat exchanger (1) according to any one of claims 1 to 14, and at least one of an electronic and an electric component (300) that is thermally connected to the connection surface (201) of the evaporator body (200).

16. Use of a power module (10) according to claim 15 in a vehicle.

## Patentansprüche

1. Ein Zweiphasenwärmetauscher (1) zum Kühlen von mindestens entweder einem elektronischen oder einem elektrischen Bauteil (300), der Wärmetauscher (1) umfassend:
a) einen Kondensatorkörper (100), umfassend mehrere Rollverbundplatten (110),
wobei ein erster Kanal (120) zwischen einem ersten und einem zweiten Blech angeordnet ist,
sodass für jede Rollverbundplatte ein erster Anschlussport (142) den ersten Kanal (120) an einem Ende begrenzt und ein zweiter Anschlussport (144) den ersten Kanal (120) an einem anderen Ende begrenzt,
wobei jedes erste Blech durch eine Rollverbindung mit einem entsprechenden zweiten Blech verbunden ist, sodass eine Rollverbundplatte (110) geformt wird, und
b) ein Verdampferelement (200), das einen zweiten Kanal (220) umfasst, wobei der zweite Kanal (220) an einem Ende durch eine dritte Anschlussöffnung (242) für jede Rollverbundplatte (110) und am an einem anderen Ende durch eine vierte Anschlussöffnung (244) für jede Rollverbundplatte (110) begrenzt wird,
wobei das Verdampferelement (200) eine thermische Verbindungsfläche (201) umfasst,
mit der mindestens ein elektronisches und elektrisches Bauteil thermal verbunden werden kann,
wobei jeder erste Anschlussport (142) mit einer entsprechenden dritten Anschlussöffnung (242) verbunden ist und wobei jeder zweite Anschlussport (144) mit einer entsprechenden vierten Anschlussöffnung (244) verbunden ist, sodass die ersten Kanäle (120) und der zweite Kanal (220) eine Schleife formen, um eine Arbeitsflüssigkeit, die eine Wärmelast aufnimmt, die durch mindestens entweder ein elektronisches oder ein elektrisches Bauteil (300) in einem Betriebszustand des Wärmetauschers (1) am Verdampferelement (200) erzeugt werden kann, von dem Verdampferelement (200) an den Kondensatorkörper (100) zu leiten, um die Wärmelast zu übertragen, und wobei die dritten Anschlussöffnungen (242) in einem ersten Endbereich (202) des Verdampferelements (200) angeordnet sind, und
**dadurch gekennzeichnet, dass** die vierten Anschlussöffnungen (244) in einem zweiten Endbereich (203) des Verdampferelements (200) angeordnet sind,
wobei der zweite Endbereich (203) an einem gegenüberliegenden Ende des Verdampferelements (200) bezüglich des ersten Endbereichs (202) angeordnet ist.

2. Der Zweiphasenwärmetauscher nach Anspruch 1, wobei die dritte Anschlussöffnung (242) und die vierte Anschlussöffnung (244) an einer gemeinsamen Kante des Verdampferelements (200) angeordnet sind.

3. Der Zweiphasenwärmetauscher nach Anspruch 2,
wobei die gemeinsame Kante an einer gegenüberliegenden Seite der Verbindungsfläche (201) an dem Verdampferelement (200) angeordnet ist.

4. Der Zweiphasenwärmetauscher nach Anspruch 3,
wobei der erste Anschlussport (142) und der zweite Anschlussport (144) an einer ersten Kante (191) des Kondensatorkörpers (100) angeordnet sind, wobei die erste Kante (191) zur gemeinsamen Oberfläche des Verdampferelements (200) weist.

5. Der Zweiphasenwärmetauscher nach Anspruch 4,
wobei die erste Kante (191) des Kondensatorkörpers (100) neben der gemeinsamen Fläche des Verdampferelements (200) verläuft.

6. Der Zweiphasenwärmetauscher nach einem der Ansprüche 2 bis 5,
wobei der erste Anschlussport (142) länger ist als der zweite Anschlussport (144), und
wobei der erste Anschlussport (142) so flexibel ist, dass er Abweichungen zwischen dem zweiten Anschlussport (144) und der dritten Anschlussöffnung (242) ausgleichen kann.

7. Der Zweiphasenwärmetauscher nach einem der vorhergehenden Ansprüche,
wobei mehrere Kondensatorelemente (100) fließend jeweils durch mehrere Sätze einer dritten Anschlussöffnung (242) und einer vierten Anschlussöffnung (244) mit dem Verdampferelement (200) verbunden sind.

8. Der Zweiphasenwärmetauscher nach Anspruch 7,
wobei mindestens zwei der dritten Anschlussöffnungen (242) und mindestens zwei der vierten Anschlussöffnungen (244) fließend durch einen gemeinsamen zweiten Kanal (220) verbunden sind.

9. Der Zweiphasenwärmetauscher nach Anspruch 8,
wobei der zweite Kanal (220) in mindestens zwei Unterkanäle zwischen den dritten Anschlussöffnungen (242) und den vierten Anschlussöffnungen (244) unterteilt ist.

10. Der Zweiphasenwärmetauscher nach einem der vorhergehenden Ansprüche,
wobei mindestens eine Dampfförderstruktur (260, 262) in dem zweiten Kanal (220) angeordnet ist.

11. Der Zweiphasenwärmetauscher nach Anspruch 10,
wobei die Dampfförderstruktur (260, 262) eine Struktur aufweist, die, wenn sie in einer Flussrichtung der Arbeitsflüssigkeit in einem Betriebszustand des Wärmetauschers im Querschnitt betrachtet wird, mehrere Unterkanäle des zweiten Kanals (220) formt.

12. Der Zweiphasenwärmetauscher nach einem der Ansprüche 1 bis 9,
wobei ein Abschnitt einer Länge des zweiten Kanals (220) oder eines Unterkanals davon durch ein Rohr mit mehreren Ports geformt wird, insbesondere eines Großteils der Länge des zweiten Kanals (220) oder des Unterkanals davon.

13. Der Zweiphasenwärmetauscher nach einem der vorhergehenden Ansprüche,
wobei der erste Kanal (120) in mindestens zwei Unterkanäle zwischen dem ersten Anschlussport (142) und dem zweiten Anschlussport (144) unterteilt ist.

14. Der Zweiphasenwärmetauscher nach einem der vorhergehenden Ansprüche,
wobei der Kondensatorkörper (100) und das Verdampferelement (200) miteinander in einem Schuss durch CAB-Löten oder Vakuumlöten verbunden sind.

15. Ein Leistungsmodul (10), umfassend:
einen Zweiphasenwärmetauscher (1) nach einem der Ansprüche 1 bis 14 und mindestens entweder ein elektronisches oder ein elektrisches Bauteil (300), das thermal mit den Verbindungsflächen (201) des Verdampferelements (200) verbunden ist.

16. Verwendung eines Leistungsmoduls (10) nach Anspruch 15 in einem Fahrzeug.

## Revendications

1. Echangeur de chaleur biphasé (1) pour refroidir au moins un parmi un composant électronique et un composant électrique (300), l'échangeur de chaleur (1) comprenant:
a) un corps de condenseur (100) comprenant une pluralité de panneaux colaminés (110), dans lequel un premier canal (120) est agencé entre une première feuille et une seconde feuille de telle sorte que pour chaque panneau colaminé un premier port de connexion (142) délimite le premier canal (120) à une première extrémité et qu'un second port de connexion (144) délimite le premier canal (120) à une autre extrémité,
dans lequel chaque première feuille est connectée à la seconde feuille par colaminage de telle sorte qu'un panneau colaminé (110) soit formé, et
b) un corps d'évaporateur (200) comprenant un second canal (220), dans lequel ledit second canal (220) est délimité à une première extrémité par une troisième ouverture de connexion (242) pour chaque panneau colaminé (110) et à une autre extrémité par une quatrième ouverture de connexion (244) pour chaque panneau colaminé (110),
dans lequel le corps d'évaporateur (200) présente une surface de connexion thermique (201) à laquelle au moins un parmi un composant électronique et un composant électrique peut être connecté thermiquement,
dans lequel chaque premier port de connexion (142) est connecté à une troisième ouverture de connexion correspondante (242), et
dans lequel chaque second port de connexion (144) est connecté à une quatrième ouverture de connexion correspondante (244), de telle sorte que les premiers canaux (120) et le second canal (220) forment une boucle pour guider un fluide de travail qui reçoit une charge thermique que peut produire ledit au moins un parmi un composant électronique et un composant électrique (300) dans un état de fonctionnement de l'échangeur de chaleur (1) au niveau du corps d'évaporateur (200) à partir du corps d'évaporateur (200) jusqu'au corps de condenseur (100) pour transférer la charge thermique, et
dans lequel les troisièmes ouvertures de connexion (242) sont agencées dans une première région d'extrémité (202) du corps d'évaporateur (200),
et **caractérisé en ce que** les quatrièmes ouvertures de connexion (244) sont agencées dans une seconde région d'extrémité (203) du corps d'évaporateur (200),
dans lequel la seconde région d'extrémité (203) est prévue sur une extrémité opposée du corps d'évaporateur (200) par rapport à la première région d'extrémité (202).

2. Echangeur de chaleur biphasé selon la revendication 1, dans lequel la troisième ouverture de connexion (242) et la quatrième ouverture de connexion (244) sont agencées sur un bord commun du corps d'évaporateur (200).

3. Echangeur de chaleur biphasé selon la revendication 2, dans lequel le bord commun est agencé sur un côté opposé de la surface de connexion (201) sur le corps d'évaporateur (200).

4. Echangeur de chaleur biphasé selon la revendication 3, dans lequel le premier port de connexion (142) et le second port de connexion (144) sont agencés sur un premier bord (191) du corps de condenseur (100), ledit premier bord (191) faisant face à la surface commune du corps d'évaporateur (200).

5. Echangeur de chaleur biphasé selon la revendication 4, dans lequel le premier bord (191) du corps de condenseur (100) s'étend à proximité de la surface commune du corps d'évaporateur (200).

6. Echangeur de chaleur biphasé selon l'une quelconque des revendications 2 à 5, dans lequel le premier port de connexion (142) est plus long que le second port de connexion (144), et dans lequel le premier port de connexion (142) est souple de manière à permettre une compensation en cas de décalage entre le second port de connexion (144) et la troisième ouverture de connexion (242).

7. Echangeur de chaleur biphasé selon l'une quelconque des revendications précédentes, dans lequel plusieurs corps de condenseur (100) sont fluidiquement connectés au corps d'évaporateur (200) par plusieurs ensembles d'une troisième ouverture de connexion (242) et d'une quatrième ouverture de connexion (244) chacun.

8. Echangeur de chaleur biphasé selon la revendication 7, dans lequel au moins deux des troisièmes ouvertures de connexion (242) et au moins deux des quatrièmes ouvertures de connexion (244) sont fluidiquement interconnectées par un second canal commun (220).

9. Echangeur de chaleur biphasé selon la revendication 8, dans lequel le second canal (220) est scindé en au moins deux sous-canaux entre les troisièmes ouvertures de connexion (242) et les quatrièmes ouvertures de connexion (244).

10. Echangeur de chaleur biphasé selon l'une quelconque des revendications précédentes, dans lequel au moins une structure de promotion de génération de vapeur (260, 262) est agencée dans le second canal (220) .

11. Echangeur de chaleur biphasé selon la revendication 10, dans lequel la structure de promotion de génération de vapeur (260, 262) présente une structure qui, lorsque l'on regarde dans une coupe transversale dans une direction d'écoulement du fluide de travail dans un état de fonctionnement de l'échangeur de chaleur, forme une pluralité de sous-canaux du second canal (220).

12. Echangeur de chaleur biphasé selon l'une quelconque des revendications 1 à 9, dans lequel une partie d'une longueur du second canal (220) ou d'un sous-canal de celui-ci est formée par un tube à ports multiples, en particulier une majorité de la longueur du second canal (220) ou du sous-canal de celui-ci.

13. Echangeur de chaleur biphasé selon l'une quelconque des revendications précédentes, dans lequel le premier canal (120) est scindé en au moins deux sous-canaux entre le premier port de connexion (142) et le second port de connexion (144).

14. Echangeur de chaleur biphasé selon l'une quelconque des revendications précédentes, dans lequel le corps de condenseur (100) et le corps d'évaporateur (200) sont connectés l'un à l'autre d'un seul coup par un brasage sous atmosphère contrôlée (CAB) ou un brasage sous vide.

15. Module de puissance (10), comprenant un échangeur de chaleur biphasé (1) selon l'une quelconque des revendications 1 à 14, et au moins un parmi un composant électronique et un composant électrique (300) qui est connecté thermiquement à la surface de connexion (201) du corps d'évaporateur (200).

16. Utilisation d'un module de puissance (10) selon la revendication 15 dans un véhicule.
